# EUROPEAN PATENT APPLICATION

(11) **EP 1 130 785 A2**
(43) Date of publication of application: **05.09.2001**
(21) Application number: 01200224.2
(22) Date of filing: 22.01.2001
(51) Int. Cl.: H03M 3/02

(54) **Signal clipping circuit for switched capacitor sigma delta analog to digital converters**

(30) Priority: 21.01.2000 US 177445 P
(71) Applicant: Texas Instruments Incorporated, Dallas, Texas 75251 (US)
(72) Inventor: Sadkowski, Roberto, Plano, Texas (US)
(74) Representative: Holt, Michael

(57) **Abstract**

A mixed signal CODEC including an improved sigma-delta ADC (20) which limits input signals into a switched capacitor configuration and avoids adding circuit overhead in the signal path is disclosed herein. Additionally, it avoids overshoot and settling problems. This sigma-delta analog-to-digital converter (20), having an- input signal and an output signal, includes a switch (sw₁), a clipping circuit (21), and a known sigma-delta ADC (34). It solves the clipping signal problem by limiting the signal right at the input of the sigma-delta ADC (34). The clipping circuit (21) couples to the switch (sw₁) and the sigma-delta ADC (34) for switching the voltage applied to the sigma-delta ADC between the input signal (νᵢₙ) and at least one threshold voltage (Vₙ and Vₚ).

## Description

### Field of the Invention

This invention relates generally to the field of electronic systems and, in particular, to signal clipping circuits for switched capacitor sigma delta analog-to-digital converters included within audio codec systems.

### Background of the Invention

The codifier/decodifier (CODEC) is the algorithm that handles the coding and decoding of audio signals within an electronic system. Specifically, an audio CODEC is a custom mixed-signal core providing analog-to-digital (A/D) and digital-to-analog (D/A) conversion. A simple serial interface is used to exchange digital data (D/A input and A/D output) between the application specific integrated circuit (ASIC) and CODEC core. Prior art CODEC features delta-sigma A/D and D/A oversampled converters and low power dissipation.

A typical uplink channel for a mobile phone voiceband or audio CODEC includes a microphone, amplifier, sigma-delta analog-to-digital converter (ADC) and a digital filter coupled together on one chip. This first chip couples to a digital signal processor for processing the digital signal received. Another chip includes a radio frequency (RF) modulator which is coupled to a last component that includes a RF power amplifier. The signal is transmitted over an antenna to a downlink channel for the mobile phone voiceband CODEC.

Initially, the audio CODEC receives an analog voice signal through the microphone and converts it to a digital signal. The digital signal is forwarded to a digital signal processor for processing. This signal is transmitted to a receiver. In the receiver, the digital signal is processed through the digital signal processor and forwarded to a D/A converter. The analog signal is fed to a speaker.

In most prior art CODECs, the sigma-delta ADC is scaled for a maximum output corresponding to the +3dbm0 code of the pulse code modulation (PCM) data. The analog signal corresponding to this digital upscale value is far less than the maximum allowable dynamic range, which usually is limited by the supply range. This fact could potentially overload the A/D and consequently the digital filter. An FCC test, mandatory in the U.S., falls under this category. Once the digital filter overloads, internal clipping mechanisms prevent wrap around of the digital signal, thus creating a digital representation of a trapezoidal signal that contains harmonics with sufficient power to increase the FM modulation depth.

First and second order sigma delta analog modulators are inherently stable under large input level variations. Higher order modulators, however, can become unstable during the overload condition. Clipping the input signal to a predetermined safe operation level, prevents the modulator from going unstable, without having the need to recover stability after the overloading condition is removed. In other cases, even inherently stable sigma-delta structures have to be protected by a clipping mechanism to prevent post digital filtering from generation of a rail-to-rail digital representation of a quasi-square wave which can over-modulate the RF channel in a typical transmit CODEC channel for wireless applications.

Several implementations have been proposed to solve this problem. Most of them deal with clipping the signal in a previous analog amplifier stage. The solution provided in our copending application includes a multiplexer amplifier having an analog output signal, a sigma-delta ADC having an input coupled to the analog output signal and a clipping circuit coupled to the input of the ADC for clipping the analog output signal. While this analog solution avoids saturation and provides an effective clipping mechanism to prevent wrap around of the digital signal, it is prone to overshoot and settling issues.

In present systems, however, the signal is fed to the A/D directly from external sources, such as a microphone or an RF mixer. Accordingly, many audio CODECs no longer include the microphone and amplifier. Thus, there is a need for a clipping solution incorporated within the design of the sigma-delta ADC that is free of overshoot and settling issues.

### Summary of the Invention

A mixed signal CODEC including an improved sigma-delta ADC limits input signals into a switched capacitor configuration and avoids adding circuit overhead in the signal path. Additionally, it avoids overshoot and settling problems. This improved sigma-delta ADC, having an input signal and an output signal, includes a switch, a clipping circuit, and a sigma-delta ADC. It solves the clipping signal problem by limiting the signal right at the input of the sigma-delta ADC. The clipping circuit couples to the switch and the sigma-delta ADC for switching the voltage applied to the sigma-delta ADC between the input signal and at least one threshold voltage. When the input signal goes above a prescribed upper threshold, the fixed threshold voltage is applied to the sigma-delta ADC, which converts fixed threshold voltage into a digital signal. Moreover, when the input signal goes below that prescribed threshold, the incoming signal is applied to the sigma-delta ADC, which converts the incoming signal. In the alternative, when the input signal goes below a prescribed lower threshold, the fixed threshold voltage is applied to the sigma-delta ADC, which converts fixed threshold voltage. Furthermore, when the input signal goes above that prescribed threshold, the incoming signal is applied to the sigma-delta ADC, which converts the incoming signal. Given this solution, minimum power and area overhead exist.

### Brief Description of the Drawings

For a more complete understanding of the present invention and the advantages thereof, reference is now made to the following description taken in conjunction with the accompanying drawings in which like reference numbers indicate like features and wherein:
Figure 1 is a schematic of a known simplified input stage of a sigma delta modulator;
Figure 2 is a schematic of a signal clipping circuit in accordance with the present invention;
Figure 3a is a diagram of the input voltage applied with respect to time; and
Figure 3b is a diagram of the clipped input voltage in accordance with the present invention.

### Detailed Description of Preferred Embodiments

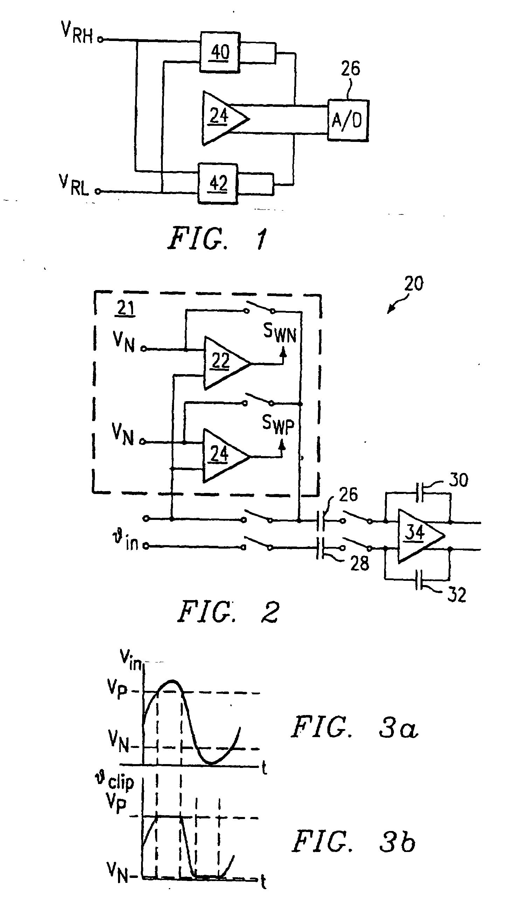

A circuit is presented here, that clips the incoming signal to predetermined levels without disturbing the signal path and adding little overhead to the power and area requirements. In Figure 1, an embodiment disclosed in our copending application, Serial No. 09/351,610, includes analog clipping circuits 40 and 42 are coupled to the differential inputs of the sigma-delta A/D 26, to avoid overdriving the sigma-delta A/D 26. The analog clipping circuits 40 and 42 add minimum overhead in area and power. For the preferred embodiment, the maximum allowable dynamic range at the input of the sigma delta A/D 26 is a minimum of 0.625 volts and a maximum 2.375 volts. The fully differential signal is 3.5 volts (+1.75 volts to -1.75 volts). Each single ended signal is clipped at a low of 0.625 volts (V_{RL}) and a high of 2.375 volts (V_{RH}). This clipping problem solution adds a pre-amp to the signal path. The amplifier then, has to perform better than the noise specification of the channel which implies high current consumption and silicon area utilization. This solution adds a constraint to the external driving source since now the input to the chip is not capacitively coupled anymore but rather has low resistance.

The voiceband CODEC having an improved sigma-delta A/D converter in accordance with the present invention is shown in Figure 2. The incoming signal νᵢₙ is connected to the comparators Cp and Cₙ, as well. Threshold voltages, Vₚ and Vₙ, are coupled to comparators, Cp and Cₙ, respectively. The incoming signal is sensed by comparators Cp and Cₙ, comparing the incoming signal with voltages Vₚ and Vₙ. Comparators Cp and Cₙ are connected to switches, swₚ and swₙ, respectively for switching in voltage levels, Vₚ and Vₙ, respectively. All three switches, sw₁, swp and swₙ, couple to a sigma-delta ADC 34. Switch sw₁ couples to receive the incoming signal νᵢₙ. Since speed and offset are not a primary concerned here, comparators, Cₚ and Cₙ, can be designed for operating at very low power. The reference voltages, Vₙ and Vₚ, may be generated from a bandgap reference or derived from the supply through a resistor/diode division.

In operation, when incoming signal νᵢₙ rises above the threshold voltage Vₚ, switch sw₁ opens and comparator Cₚ turns on, closing switch swp. Accordingly, the fixed voltage Vₚ is supplied to the sigma delta ADC 34. When the value of the signal goes below the threshold voltage, comparator Cₚ shuts off, opening switch swₚ. Simultaneously, switch sw₁ closes and incoming signal νᵢₙ is supplied directly to sigma-DAC 34.

When incoming signal νᵢₙ goes below threshold voltage Vₙ, switch sw₁ opens and comparator Cₙ turns on, closing switch swₙ. Accordingly, the fixed voltage Vₙ is supplied to the sigma delta ADC 34. When the value of signal νᵢₙ rises above the threshold voltage Vₙ, the comparator Cₙ shuts off, opening switch swₙ. Simultaneously, switch sw₁ closes and incoming signal νᵢₙ is supplied directly to the sigma delta ADC.

Figure 3a displays the input signal νᵢₙ, while Figure 3b shows the clipped input signal ν_{clip} seen by the sigma-delta ADC 34. As shown in Figure 3b, when incoming signal νᵢₙ rises above the threshold voltage Vₚ, switch sw₁ opens and comparator Cₚ turns on, closing switch swₚ. As a result, the voltage V_{clip} is equal to the threshold voltage Vₚ. When the value of the signal νᵢₙ goes below the threshold voltage Vₚ, the comparator Cp shuts off, opening switch swₚ. Switch sw₁ closes and, as a result, voltage ν_{clip} equals the incoming signal νᵢₙ. When the incoming signal νᵢₙ goes below threshold voltage Vₙ, switch sw₁ opens and the comparator Cₙ turns on, closing switch swₙ. Accordingly, voltage ν_{clip} equals the fixed voltage Vₙ.

Those skilled in the art to which the invention relates will appreciate that various substitutions, modifications and additions can be made to the described embodiments, without departing from the spirit and scope of the invention.

## Claims

1. A sigma-delta analog-to-digital converter, having an input signal and an output signal comprising:
a clipping circuit coupled to a switch for switching between the input signal and at least one threshold voltage;
a sigma-delta analog-to-digital converter having an input coupled to an output of the clipping circuit.

2. The device of claim 1, wherein the clipping circuit comprises a first branch for clipping the output signal at an upper boundary, and a second branch for clipping the output signal at a lower boundary.

3. The device of claim 2, wherein the first branch comprises:
a comparator having an output, a first input coupled for receiving first threshold voltage and a second input coupled for receiving the input signal; and
a switch coupled to the output of the comparator, the output voltage of the comparator coupled to the switch to open and close the switch.

4. The device of claim 2 or Claim 3, wherein the second branch comprises:
a comparator having an output, a first input coupled for receiving a first threshold voltage and a second input coupled for receiving the input signal; and
a switch coupled to the output of the comparator, the output voltage of the comparator coupled to the switch to open and close the switch.

5. The device of any preceding claim, wherein the first input of the comparator is a negative input and the second input of the comparator is a positive input.
